# EUROPEAN PATENT APPLICATION

(11) **EP 4 615 176 A1**
(43) Date of publication of application: **10.09.2025**
(21) Application number: 24161972.5
(22) Date of filing: 07.03.2024
(51) Int. Cl.: H05K 5/02, F16L 5/10, H02G 3/08, H02G 15/013

(54) **BOX, HEAT PUMP BOX COMPRISING THE BOX, METHOD FOR MANUFACTURING THE BOX, AND USE OF AN OVERMOLDED CABLE GROMMET INSTALLABLE IN THE BOX**

(71) Applicant: BDR Thermea Group B.V., 7332 BD Apeldoorn (NL)
(72) Inventor: SIEGEL, Olivier, 7332 BD Apeldoorn (NL); KIEFFER, Damien, 7332 BD Apeldoorn (NL); KOCH, Mickaël, 7332 BD Apeldoorn (NL); ANTOINE, Florian, 7332 BD Apeldoorn (NL)
(74) Representative: Grabovac, Dalibor

(57) **Abstract**

A box adapted to be installed inside a heat pump box, the box optionally being one of an electric equipment box and a refrigerant box, the box comprising: a box panel comprising a slot; and an overmolded cable grommet, molded around a wire, wherein the overmolded cable grommet is arranged inside the slot, contacts an edge of the slot and extends onto a first surface of the box panel, such that the overmolded cable grommet is restricted from moving in at least one direction that is perpendicular to the first surface, and wherein the box is substantially air-tight when an electronic device inside the box is connected to a source that is external to the box via the wire passing through the overmolded cable grommet.

## Description

### TECHNICAL FIELD

The present disclosure relates to a housing installable in a heat pump system. The present disclosure further relates to a heat pump system comprising the housing and to a method for manufacturing the housing. The present disclosure further relates to a use of a molded cable grommet for air-tightening the housing.

### BACKGROUND

Heat pump systems are getting more and more sophisticated and therefore more and more electronic components are used for the control of heat pump systems. These electronic components may be provided in a certain housing, like e.g. an electronic component box or electric equipment box. At the same time, heat pump systems, especially those using flammable refrigerants, demand an air-tight seal to preclude the potential of these refrigerants, such as from leakage, from contacting any ignition sources either within or outside the heat pump system. This is particularly crucial for certain parts of the heat pump, most notably the electronic component box. However, openings must be included in such a box, for running cables through, connecting a component inside the box to an external source and/or output. Nowadays, several solutions comprising means of cable entry systems for cables with connectors exist for air-tightening the openings. However, such solutions are often rather complex and thus expensive.

### TECHNICAL PROBLEM

Flammable refrigerant, like an A3 class refrigerant such as propane, must be prevented from coming into contact with electronic components. By regulation, the concentration of an A3 class refrigerant may not exceed 25% of the lower flammability limit (LFL) in the direct surroundings of such components. Hereto, such components are commonly placed inside an electronic component box and/or at least some, preferably all, components of the refrigeration circuit on which refrigerant flows (compressor, heat exchangers, circuits, expansion valve, etc) may be enclosed by another box, a so-called refrigerant box. To make such a box air-tight, preventing flammable refrigerant from entering or exiting, a proper sealing along any junction is necessary. This is typically done by the means of cable entry systems for cables with connectors. However, such cable entry systems are often rather complex and thus expensive. Additionally, such cable entry systems may not satisfy the requirements regarding the air-tightening against flammable refrigerants. Hence, there is need for improvement. It is therefore an object of the present disclosure to provide such improvement.

### SUMMARY

At least part of the drawbacks of the nowadays solutions are overcome based on the present disclosure. I.e., the object to provide an improvement over the prior art is achieved based on the present disclosure.

In particular, according to a first aspect, there is disclosed a box adapted to be installed inside a heat pump housing, the box optionally being one of an electric equipment box and a refrigerant box. The box comprises a box panel comprising a slot; and an overmolded cable grommet, molded around a wire. The overmolded cable grommet is arranged inside the slot, contacts an edge of the slot and extends onto a first surface of the box panel, such that the overmolded cable grommet is restricted from moving in at least one direction that is perpendicular to the first surface. The box is substantially air-tight when an electronic device inside the box is connected to a source that is external to the box via the wire passing through the overmolded cable grommet.

The solution according to the first aspect is advantageous over existing solutions, in that it is less expensive, especially compared to split cable entry systems. The assembly of such solution is timesaving in that it is comparatively quick and easy, for example since pre-assembled building blocks may be used, like the box and the cable around which the grommet has been molded. Moreover, any air-tightening is not impacted by wire or cable dimension variations and tolerances. In addition, no tightening torque guaranteeing may be necessary. Further, based on the solution according to the first aspect, it is enabled to fit bulky components, like a pre-wired control board, connectors or fairings, a pre-wired driver coil, a filter pre-mounted on a harness or components, for example, inside the box, without decrease the ability to fulfill air-tightness requirements.

Moreover, according to several examples, the overmolded cable grommet arranged inside the slot may be adapted to have restricted movement in both directions perpendicular to the first surface. Both directions may be understood to comprise a positive direction perpendicular to the first surface and a negative direction perpendicular to the first surface. Preferably, the overmolded cable grommet may further extend onto a second surface of the box panel opposite to the first surface.

Due to the movement being restricted in both directions perpendicular to the first surface, the overmolded cable grommet is held in the slot more reliably. This is particularly advantageous in view of push-pull requirements set forth in particular tests and (safety) standards limiting the amount of distance a cable may move through an opening, as the overmoulded cable grommet should be in a substantially fixed position along the length direction of the cable, such that upon installation, the movement of the cable with respect to the opening is restricted in both directions. Particularly, in case the overmolded cable grommet further extends onto the second surface, the overmolded cable grommet is held in the slot with even more increased reliability, preventing substantially all pushing and pulling onto the cable from the cable traveling with respect to the opening.

Moreover, according to several examples, the overmolded cable grommet, when considered in a thickness-direction of the box panel, may comprise a first portion and a second portion. The first portion being configured to have a complementary shape, complementary to a shape of the slot. The second portion is arranged on a first side of the first portion and is configured to have a perimeter shape adapted to extend beyond the edge of the slot. The overmolded cable grommet may be arranged so that the first portion is arranged inside the slot, and so that the second portion is arranged outside the slot and extends onto the first surface of the box panel, such as to substantially close the slot in an air-tight manner.

Such configuration of the overmolded cable grommet comprises several advantages. For example, since the second portion may extend onto the first surface of the box panel to substantially close the slot in an air-tight manner, the first portion may not necessarily close or fill the slot entirely, i.e. in an air-tight manner. Hence, the first portion may be configured to arrange the overmolded cable grommet inside the slot by use of a locking mechanism, for example, without the necessity to also guarantee an air-tight closure. Hence, the first portion may be configured to focus on arranging the overmolded cable grommet inside the slot in a potentially most reliable, repeatable and/or convenient manner. Moreover, a complementary shape may comprise that a shape of the overmolded cable grommet matches a shape of the slot, for example in that the shape of the overmolded cable grommet is the negative of the shape of the slot. Hereto, or alternatively, the first portion may be molded with a softer material, i.e. material with a lower shore hardness, than the remaining part of the grommet, providing the grommet with one or more zones that are more flexible to slide into the opening and/or compensate for irregularities/tolerances. Further, complementary shape may also comprise that the shape of the overmolded cable grommet corresponds to the shape of the slot in a key-to-keyhole manner, meaning that an overmolded cable grommet having a certain shape may only be arranged inside a slot having a correspondingly certain shape and optionally only in one rotational position such as to determine/prevent an amount of torsion in the wire-section inside the box. The shape of the second portion may be any shape as long as the slot is closed in an air-tight manner.

Moreover, according to several examples, the overmolded cable grommet may further comprise a third portion arranged on a second side of the first portion opposite to the first side and having a perimeter shape adapted to at least partially extend beyond the edge of the slot. The overmolded cable grommet may further be arranged so that the third portion is arranged outside the slot and extends onto the second surface of the box panel.

Accordingly, the overmolded cable grommet is held in the slot with even more increased reliability. Moreover, the second and the third portions may each close the slot in a substantially air-tight manner. Hence, reliability of the air-tight closing is further increased.

Moreover, according to several examples, the box may further comprise a closing panel for opening and closing the box, wherein the closing panel contacts an edge of the box panel. The slot may be arranged at the edge of the box panel so that at least part of the edge of the slot is formed by the closing panel.

Accordingly, in case the closing panel is removed, the overmolded cable grommet may be slid in position and may be held in position inside the slot once the closing panel is rearranged. Hence, the closing panel may at least to some extent hold or compress the arranged overmolded cable grommet inside the slot. Hence, a pushing of the overmolded cable grommet through the slot may be avoided and a deformation of the overmolded cable grommet during the arrangement of the overmolded cable grommet inside the slot is at least reduced. At the same time, having to push- or pull-through a potentially lengthy section of cable through the slot is prevented. Therefore, a risk of damaging the overmolded cable grommet and cable during the arrangement is reduced. Moreover, such sliding in and out of position may allow to rearrange the overmolded cable grommet several times inside the slot without putting any stress on the overmolded cable grommet, which may occur when pushing or pulling the overmolded cable grommet. This configuration is considered particularly advantageous, as the large opening provided by the closing panel, which may also be a door, enables bulky (pre-wired) components, like a pre-wired control board, connectors or fairings, a pre-wired driver coil, a filter pre-mounted on a harness or components, for example, being fitted inside the box with the aforementioned time-saving advantage of providing the overmolded grommet ahead of installation. Furthermore, replacement of the overmolded cable grommet may be facilitated.

Moreover, according to several examples, the overmolded cable grommet may further comprise a compressible material and may further have a tapered and/or threaded portion configured to be pushed through the slot and/or optionally through a small hole that is optionally provided adjacent to the slot. The tapered and/or threaded portion may widen, in a direction from an end section of the overmolded cable grommet to a middle section of the overmolded cable grommet, to a diameter which is larger in an uncompressed state than a largest diameter of the slot or of the optional small hole. The overmolded cable grommet may be arranged inside the slot by being pushed through the slot and optionally through the small hole, so that a section of the tapered and/or threaded portion is compressed at the slot and/or the optionally provided small hole.

Accordingly, the tapered and/or threaded portion may provide any easy solution for arranging the overmolded cable grommet inside the slot. Moreover, pushing such tapered and/or threaded portion alternatively and optionally through a small hole provided adjacent to the slot, the overmolded cable grommet may be held in position even more reliably and an air-tight closure is provided with even more reliability.

Moreover, according to several examples, the slot of the box panel may represent a first slot and wherein the overmolded cable grommet may represent a first overmolded cable grommet. The box panel may further comprise a second slot, which has a size and/or shape different from the first slot. The box may further comprise a second overmolded cable grommet. The respective first and second overmolded cable grommets each being adapted to fit a respective one of the first and second slots.

Accordingly, errors in the arrangement of different overmolded cable grommets in different slots is at least reduced, in that it may be avoided that an overmolded cable grommet is arranged inside a wrong slot, i.e. inside a slot where another overmolded cable grommet is intended for arrangement. Furthermore, an installation of devices inside the box is provided with higher flexibility, since several different slots comprising several different overmolded cable grommets being molded around several different wires may be used.

Moreover, according to several examples, the slot may represent a first slot and wherein the overmolded cable grommet may represent a first overmolded cable grommet molded around a first wire. The box panel may further comprise a second slot and the box may further comprise a second overmolded cable grommet molded around a second wire and arranged in the second slot. When the first and second overmolded cable grommets are arranged in the first and second slots, the first and second wires may extend to different lengths inside the box.

Accordingly, since the first and second wires may extend to different lengths inside the box, the first and second wires may be connected to different devices inside the box. For example, the different devices inside the box may be arranged inside the box so that a wire, which extends to a comparatively short length inside the box, may only be connected to a certain device inside the box, which is arranged comparatively close to the box panel comprising the slot in which the overmolded cable grommet comprising the wire of the comparatively short length is arranged. Hence, installation errors may be even further reduced.

Moreover, according to several examples, the overmolded cable grommet may have a bulb shape having a cylindrical-shaped portion to be arranged at least partially inside the slot and a circular-shaped portion arranged outside the slot, wherein the circular-shaped portion has a diameter between 10mm and 30mm. Additionally or alternatively, the overmolded cable grommet arranged inside the slot may have a maximum diameter of equal to or less than 25mm. Additionally or alternatively, the overmolded cable grommet may comprise at least one of: ABS, EPDM rubber, PBT, PVC, TPE, hotmelt resin, and nylon. Additionally or alternatively, the overmolded cable grommet may be overmolded using at least two materials of different hardness, in particular shore hardness, such that a predetermined section may be softer and/or more flexible to accomodate higher tolerances and/or imperfections. Additionally or alternatively, the overmolded cable grommet may be configured to shrink around and/or bond to an outer surface of the wire to pass through the overmolded cable grommet. Additionally or alternatively, the overmolded cable grommet may be an air-tight clip-on plastic piece to the slot from the box panel. Additionally or alternatively, the overmolded cable grommet may be interference fitted into the slot. Additionally or alternatively, the overmolded cable grommet may be molded directly onto the wire, wherein the grommet preferably is fixed to the cable, such that no translation of the grommet along the cable is possible.

Hence, a variety in applying the overmolded cable grommet is increased. In particular, the maximum diameter of equal to or less than 25mm may enable an application of the overmolded cable grommet on a huge variety of different wires.

According to a second aspect, there is disclosed a heat pump housing in which the box according to the first aspect is installed. The heat pump housing may preferably further comprise a refrigerant circuit in which a flammable refrigerant is used. The flammable refrigerant may preferably be propane.

The solution according to the second aspect is advantageous over existing solutions, in that the heat pump housing may be equipped with the advantageous box according to the first aspect. Moreover, the box according to the first aspect may be used in different ways. For example, to avoid a flammable refrigerant leaking from the refrigerant circuit to reach electronic devices, which are protected inside the box. Additionally or alternatively, in case the refrigerant circuit may be installed inside the box according to the first aspect, a flammable refrigerant leaking from the refrigerant circuit may not exit the box. Hence, electronic devices outside the box are protected.

According to a third aspect, there is disclosed a method for manufacturing a box installable in a heat pump housing according to the first aspect. The method comprises providing a box panel comprising a slot for passing a wire through. The method further comprises providing at least one wire with a cable grommet by overmolding said cable grommet around the wire at a predetermined longitudinal position along the wire, using a mold shape that is adapted to result in a cable grommet having a shape complementary to a shape of the slot such that the cable grommet closes off the slot in a substantially air-tight manner and is restricted from moving in at least one direction perpendicular to a surface of the box panel after placement in the slot. The method further comprises placing the overmolded cable grommet within the slot of the box panel.

The solution according to the third aspect is advantageous over existing solutions, in that it provides a less expensive, timesaving and easily to implement solution, for example since pre-assembled building blocks may be used, like the box and the cable around which the grommet has been molded. Moreover, an air-tightening is not impacted by wire or cable dimension variations and tolerances. In addition, no tightening torque guaranteeing may be necessary. Further, such manufacturing enables to fit bulky components, like a pre-wired control board, connectors or fairings, a pre-wired driver coil, a filter pre-mounted on a harness or components, for example, inside the box, without decrease the ability to fulfill air-tightness requirements.

Moreover, according to several examples, the step of providing the box panel comprising the slot may comprise the providing of the slot at an edge of the box panel, such that an edge of the slot forms a part of the edge of the box panel. The placing of the overmolded cable grommet may comprise the sliding of the cable grommet into the slot in a direction substantially parallel to a surface of the box panel.

Accordingly, a pushing of the overmolded cable grommet through the slot may be avoided and a deformation of the overmolded cable grommet during the arrangement of the overmolded cable grommet inside the slot is at least reduced. Therefore, a risk of damaging the overmolded cable grommet during the arrangement is reduced. Moreover, such sliding in and out of position may allow to rearrange the overmolded cable grommet several times inside the slot without putting any stress on the overmolded cable grommet, which may occur when pushing or pulling the overmolded cable grommet. Furthermore, replacement of the overmolded cable grommet may be facilitated.

Moreover, according to several examples, the placing of the overmolded cable grommet may comprise pushing the overmolded cable grommet into the slot in a direction substantially perpendicular to a surface of the box panel. Optionally, the placing further comprises rotating the overmolded cable grommet in a direction substantially parallel to the surface to establish a locking of the overmolded cable grommet in both directions substantially perpendicular to the surface. Both directions may be understood to comprise a positive direction perpendicular to the surface and a negative direction perpendicular to the surface.

Accordingly, the arrangement of the overmolded cable grommet may be facilitated in that merely a pushing is required and any tools may be avoided. Moreover, due to the rotating the overmolded cable grommet, the overmolded cable grommet may be locked inside the slot more reliably. Further, an air-tight closure is provided with even more reliability.

Moreover, according to several examples, the method may further comprise providing the box panel with a second slot for passing a wire through. The second slot preferably has a different shape and/or size from the slot. The method may further comprise providing another wire with a second cable grommet by molding said second cable grommet around the another wire at another predetermined longitudinal position along the another wire, using a second mold shape that is adapted to result in a cable grommet having a shape complementary to a shape of the second slot.

Accordingly, errors in the arrangement of different overmolded cable grommets in different slots is at least reduced, in that it may be avoided that an overmolded cable grommet is arranged inside a wrong slot, i.e. inside a slot where another overmolded cable grommet is intended for arrangement. Furthermore, an installation of devices inside the box is provided with higher flexibility, since several different slots comprising several different overmolded cable grommets being molded around several different wires may be used.

According to a fourth aspect, there is disclosed a use of an overmolded cable grommet for air-tightening a wire entry of a box installable in a heat pump housing. The box comprises a box panel comprising a slot. The use comprises arranging the overmolded cable grommet inside the slot to contact an edge of the slot and to extend onto a first surface of the box panel.

The solution according to the fourth aspect is advantageous over existing solutions, in that it is less expensive, especially compared to split cable entry systems. The assembly of such solution is timesaving in that it is comparatively quick and easy, for example since pre-assembled building blocks may be used, like the box and the cable around which the grommet has been molded. Moreover, an air-tightening is not impacted by wire or cable dimension variations and tolerances. In addition, no tightening torque guaranteeing may be necessary. Further, based on the solution according to the first aspect, it is enabled to fit bulky components, like a pre-wired control board, connectors or fairings, a pre-wired driver coil, a filter pre-mounted on a harness or components, for example, inside the box, without decrease the ability to fulfill air-tightness requirements.

The present disclosure may include one or more aspects, examples or features in isolation or combination whether specifically disclosed in that combination or in isolation. Any optional feature or sub-aspect of one of the above aspects applies as appropriate to any of the other aspects.

The above-described aspects will become apparent from, and elucidated with, reference to the detailed description provided hereinafter.

### BRIEF DESCRIPTION OF THE DRAWINGS

In the Figures, the subject-matter of the present disclosure is schematically shown, wherein identical or similarly acting elements are usually provided with the same reference signs. Hence, a detailed description will now be given, by way of example only, with reference to the accompanying drawing, in which:
- Figure 1 shows a heat pump system comprising a box according to several examples of the present disclosure;
- Figure 2 shows the box according to several examples of the present disclosure;
- Figure 3 shows the box in a close-up view according to several examples of the present disclosure;
- Figure 4 shows the box in a close-up view according to several examples of the present disclosure;
- Figure 5 shows the box in a close-up view according to several examples of the present disclosure;
- Figure 6 shows the box in a close-up view according to several examples of the present disclosure;
- Figure 7 shows the box comprising wires in a close-up view according to several examples of the present disclosure;
- Figure 8 shows a box according to several examples of the present disclosure;
- Figure 9 shows an inside of the box according to several examples of the present disclosure;
- Figure 10 schematically shows in a top-view perspective an overmolded cable grommet arranged in a slot of the box according to several examples of the present disclosure;
- Figure 11 schematically shows in a top-view perspective an overmolded cable grommet arranged in a slot of the box according to several examples of the present disclosure;
- Figure 12 schematically shows in a top-view perspective an overmolded cable grommet arranged in a slot of the box according to several examples of the present disclosure;
- Figure 13 schematically shows in a side-view perspective the overmolded cable grommet according to Figure 10, according to several examples of the present disclosure;
- Figure 14 schematically shows in a side-view perspective the overmolded cable grommet according to Figure 11, according to several examples of the present disclosure;
- Figure 15 schematically shows in a side-view perspective the overmolded cable grommet according to Figure 12, according to several examples of the present disclosure;
- Figure 16 shows from a first perspective an overmolded cable grommet according to several examples of the present disclosure;
- Figure 17 shows from a second perspective the overmolded cable grommet according to several examples of the present disclosure; and
- Figure 18 shows a flowchart according to several examples of the present disclosure.

### DETAILED DESCRIPTION

According to the present disclosure, a molded grommet for overmolded cable grommet may guarantee substantial air-tightness while allowing the use of pre-mounted wires with a size bigger than diameters of wires of connectors, pre-wired control boards, ferrites, pre-wired driver coils, and/or filters pre-mounted on the wires. It shall be noted that by the term "wire" also a cable is comprised since a cable comprises at least one wire.

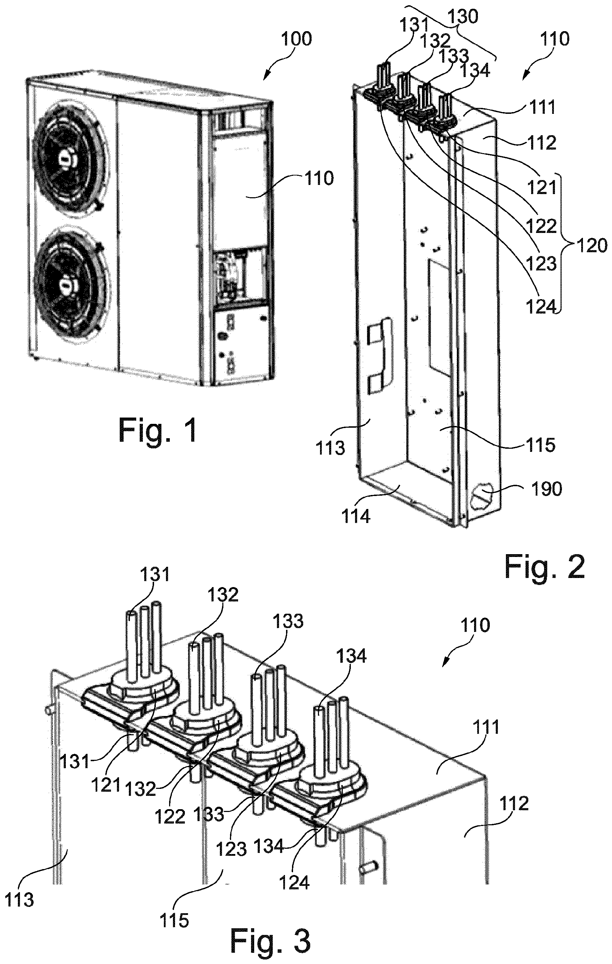

Referring now to Figure 1, Figure 1 shows a heat pump system 100 comprising a box 110. The heat pump system 100 may comprise a propane unit, i.e. a refrigerant loop in which propane as a flammable refrigerant is used, for example, and the box 110 may be understood to represent a control box or electronic component box comprising at least one electronic device, i.e. at least one electronic device arranged inside the box. Additionally or alternatively, another of the box 110 may comprise the propane unit or at least part thereof, i.e. the propane unit or at least part thereof may be arranged inside such box 110.

In more detail, the box 110 of the heat pump system 100 as illustrated according to Figure 1 comprises the at least one electronic device, which may be able to ignite a flammable refrigerant like propane for example, and the heat pump system 100 further comprises, outside the box 110, the refrigerant loop using the flammable refrigerant. The box 110 may thus comprise inside the box 110 an electronic device that could get hot and/or could create a spark which may ignite the flammable refrigerant if the flammable refrigerant may potentially leak from the refrigerant loop into the box 110.

Figures 2 to 7 show the box 110 in more detail. The box 110 has a cuboid shape, but may have the shape of any volumetric body, which is installable in a heat pump system and inside which an electronic device may be arranged. In Figure 2, for example, the box 110 is shown with five panels 111 to 115 out of its six panels, wherein the sixth panel is removed and thus not shown. The sixth panel may be a closing panel, which may be opened and closed to get access to the inside of the box 110, for example. Further, according to several examples of the present disclosure, the box 110 comprises at least one slot in one of the panels. In Figures 2 to 7, the at least one slot is provided in the panel 111. In particular, four slots 141, 142, 143 and 144 are provided in the panel 111, but there may be less or more than four slots provided in the panel 111. Additionally or alternatively, further slots may be provided in different panels of the box 110. The panel 110 comprises four edges, i.e. the edge 111a, which is interrupted by the four slots 141, 142, 143 and 144, the edge 111b adjacent to the edge 111a, the edge 111c adjacent to the edge 111b and opposite to the edge 111a, and the edge 111d adjacent to the edge 111a and opposite to the edge 111b. Further, each of the slots 141, 142, 143 and 144 comprises a corresponding edge or slot edge 141a, 142a, 143a and 144a. The slots 141, 142, 143 and 144 are arranged at the edge 111a of the panel 111, so that the corresponding edges 141a, 142a, 143a and 144a form part of the edge 111a of the panel 111. Hence, a perimeter of the panel 111 may be understood as a sum over the edges 111a, 111b, 111cand 111d as well as the slot edges 141a, 142a, 143a and 144a. Hence, the slots 141, 142, 143 and 144 may thus be understood to represent recesses of the plate 111. However, at least one of the slots 141, 142, 143 and 144 may be arranged differently. For example, at least one of the slots 141, 142, 143 and 144 may be arranged in the panel 111 to be completely surrounded by the panel 111. I.e., at least one of the slots 141, 142, 143 and 144 may not be arranged at an edge of the panel. Accordingly, such slot may be understood to represent an opening of the panel 111. At least one of the slots 141, 142, 143 and 144 may be different in size and/or shape.

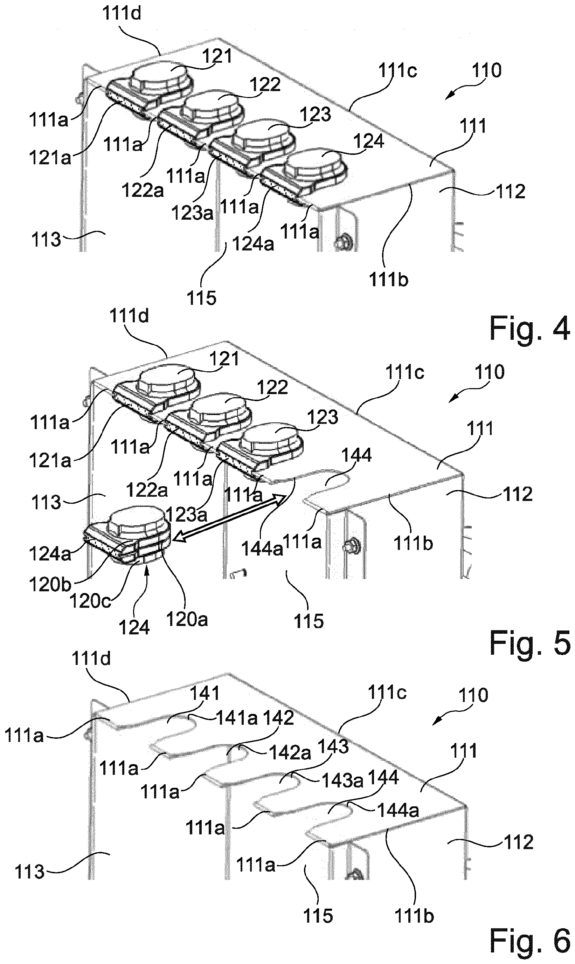

Furthermore, due to such arrangement of the slots 141, 142, 143 and 144 at the edge 111a of the panel 111 as illustrated in Figure 5, for example, an overmolded cable grommet 120 or overmolded cable grommets 121, 122, 123 and 124 may be slid into position as illustrated by the arrow shown in Figure 5 for example, in case the closing panel is removed from the box 110. The sliding may be performed in a direction substantially perpendicular to a normal vector of the plane 111, preferably in a direction pointing from the edge 111a toward the edge 111c in a direction substantially perpendicular to the extension direction of the edge 111c. In case the overmolded cable grommets 121, 122, 123 and 124 are slid into the corresponding slots 141, 142, 143 and 144, the edge 111a of the panel 111 may be understood to be interrupted by the edges 121a, 122a, 123a and 124a of the corresponding overmolded cable grommets 121, 122, 123 and 124, as illustrated in Figure 4, for example. Hence, the perimeter of the panel 111 may be understood as a sum over the edges 111a, 111b, 111c and 111d as well as the edges 121a, 122a, 123a and 124a of the overmolded cable grommets 121, 122, 123 and 124. Therefore, in case the box 110 may be closed in that the closing panel will be rearranged, the closing panel will contact the edge 111a of the panel 111 and the edges 121a, 122a, 123a and 124a of the overmolded cable grommets 121, 122, 123 and 124. If the closing panel is arranged at the box 110, the contact between the closing panel and the edge 111a as well as the edges 121a, 122a, 123a and 124a of the overmolded cable grommets 121, 122, 123 and 124 is substantially air-tight. Hereto, the closing panel may be tightly fixed against the edge 111a as well as the edges 121a, 122a, 123a and 124a of the overmolded cable grommets 121, 122, 123 and 124. The presence of the closing panel prevents removal and/or displacement of the overmolded cable grommets 121, 122, 123 and 124.

Each of the overmolded cable grommets 121, 122, 123 and 124 as shown in Figure 5, for example, may be understood to comprise a first portion 120a, a second portion 120b and a third portion 120c, as illustrated with reference to the overmolded cable grommet 124, for example. The second and third portions 120b and 120c are arranged on either side of the first portion 120a. Hence, the first portion 120a may represent a middle portion of the overmolded cable grommet 124. The first portion 120a is slid into the corresponding slot 144 to arrange the overmolded cable grommet 124 inside the slot 144. When arranged inside the slot 144, the second and third portions 120b and 120c are each of a shape to extend at least partly beyond the slot edge 144a onto the plate 111. In particular, the second and third portions 120b and 120c extend onto the opposite surfaces of the plate 111, respectively. Since both of the second and third portions 120b and 120c extend at least partly beyond the slot edge 144a, both a positive and a negative direction parallel to the normal vector of the plane 111 are blocked for movement of the overmolded cable grommet 124, and the overmolded cable grommet 124 is held in position more reliably. Moreover, in case both of the second and third portions 120b and 120c extend entirely beyond the slot edge 144a, reliability of an air-tight closure may be increased, since each of the second and third portions 120b and 120c alone may already close the slot 144 in an air-tight manner. Thus, it may be sufficient if only one of the second and third portions 120b and 120c extends entirely beyond the slot edge 144a. Moreover, according to several examples of the present disclosure, an air-tight closure may already be achieved based on the first portion 120a being arranged inside the slot 144 and based on such arranged first portion 120a closing the slot 144 in a substantial air-tight manner. Hence, for reasons of an air-tight closure, the overmolded cable grommets 121, 122, 123 and 124 may comprise the first portion 120a only. Additionally, it shall be noted that the shape of the first portion 120a and its countershape, i.e. the slot edge 144a, prevent translation in the horizontal plane, i.e. a plane parallel to the plane 111, and/or a rotation about the vertical axis, i.e. an axis parallel to the normal vector of the plane 111. Thus, the combination of the three portions 120a, 120b and 120c prevent any rotation and translation of the wire and/or the overmolded cable grommet (except for the sliding in into the slot 144, which will, however, be locked by the additional closing panel not shown here).

Hence, the overmolded cable grommets 121, 122, 123 and 124 allow to close the slots 141, 142, 143 and 144 in a substantially air-tight manner and, at the same time, provide an inexpensive, easily arrangeable and installable as well as individually applicable solution for running wires from the outside of the box 110 to the inside of the box 110, wherein flammable refrigerants are kept outside the box 110.

Due to the usage of propane as indicated above, there is a need of inserting pre-mounted wires 131, 132, 133 and 134 or cables with connectors into the box 110, in order to avoid taking a risk of tightness of the box 110. The slots 141, 142, 143 and 144 eliminate the constraints imposed by the presence of connectors on the wires 131, 132, 133 and 134 or cables. An elasticity of the grommet material may be used to make a material interference, i.e a thickness of the overmolded cable grommet 121, 122, 123 and 124 inside the slot 141, 142, 143 and 144 may be smaller than 1mm, which may be lower than the thickness of the box panel 111 of 0.8 mm to 2.5 mm, preferably approximately 1mm.

Hence, the present specification discloses overmolded cable grommets 121, 122, 123 and 124 for wires 131, 132, 133 and 134, the overmolded cable grommets 121, 122, 123 and 124comprising a rubber material such as polyamide hot melt resin or elastomer pressure die-casted, for example. The overmolded cable grommets 121, 122, 123 and 124 may allow to encapsulate pre-assembled wires 131, 132, 133 and 134 with compounds. Such overmolded cable grommets 121, 122, 123 and 124 may be fixed on the box 110, i.e. fixed to the respective slots 141, 142, 143 and 144, and may guarantee a sealing level to A2/A3 gas in case of leakage to be compliant to heat pump regulation. The present specification is based on i.a. the idea to prevent contact between a refrigerant from a leakage and a potential ignition source such as an electronic device like a control board inside the box 110, for example.

Hence, an air-tight seal is ensured to prevent passage of any potentially leaked flammable refrigerant into the box 110. With other words, the overmolded cable grommets 121, 122, 123 and 124 prevent any refrigerant from entering the box 110. Air-tight thus also means refrigerant-tight. As such, the box 110 of the heat pump system 100 passes the refrigerant leak simulation test according to appendix FF of IEC 60335-2-40.

In this regard, the solution as disclosed herein allows for air-tightness of the box 110 to be less than one liter per minute of leakage flow at 50 Pa. The overmolded cable grommets 121, 122, 123 and 124 further have fire-resistant properties and flexibility. Leakage flow in this specification may be understood to represent a mixture of air with propane.

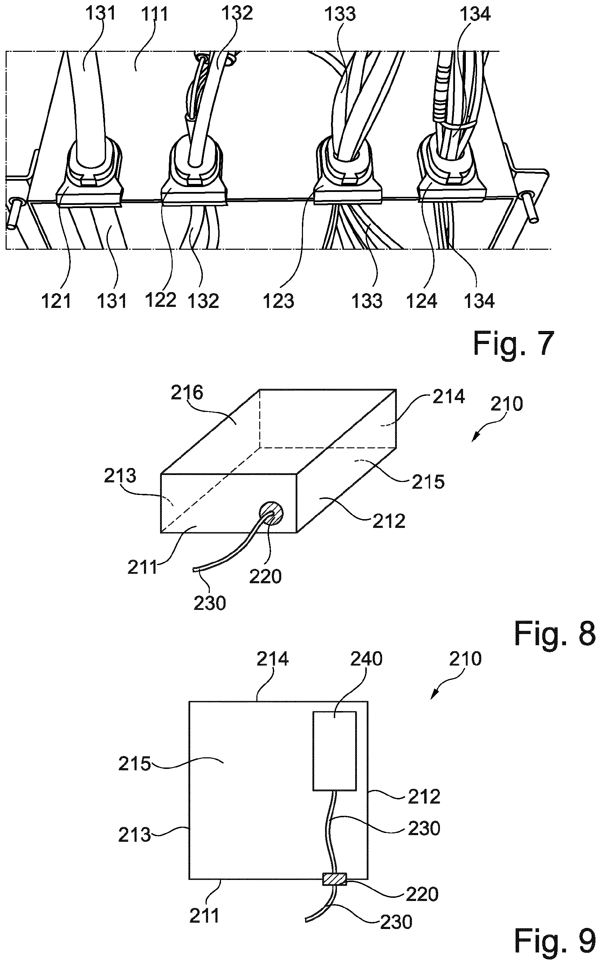

Figures 8 to 15 show an alternative box 210 to such box 110 as outlined above with reference to Figures 2 to 7. The box 210 according to Figures 8 to 15 differs from the box 110 according to Figures 2 to 7 in that the at least one slot 250, 260, 270 is not arranged at an edge of a panel 211 of the box 210 but is arranged to be surrounded by the panel 211. The advantages and capabilities of the box 110 as outlined above with reference to Figures 2 to 7 also hold true for the box 210 according to Figures 8 to 15, as appropriate.

The box 210 is of a cuboid shape and comprises six panels 211 to 216. However, the box 210 may have a shape of any volumetric body. In Figures 8 to 10, the overmolded cable grommet 220 is indicated to be positioned inside the slot 250, wherein a wire 230 is running through the overmolded cable grommet 220 from the outside of the box 210 to the inside of the box 210 to connect at least one electronic device 240 arranged inside the box 210.

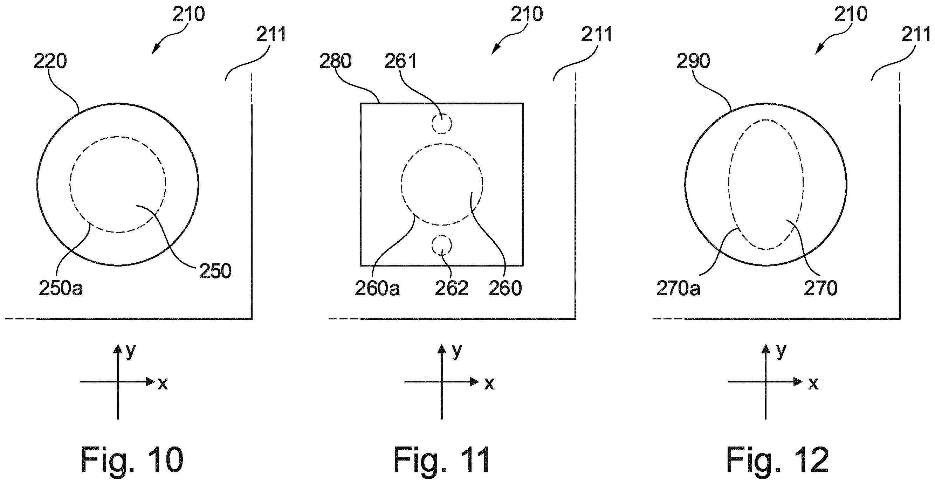

Figure 10 shows a close-up perspective of the overmolded cable grommet 220 arranged inside the slot 250 of the panel 211 of the box 210, according to various examples of the present disclosure. In a cartesian coordinate system, the plane 211 as shown in Figure 10 lies in the x-y-plane, wherein a normal vector of the plane 211 is parallel to the z-axis.

The overmolded cable grommet 220 has a substantially circular shape, for example. The slot 250 in the plane 211 has a substantially circular shape comprising a substantially circular-shaped edge 250a. The overmolded cable grommet 220 extends entirely beyond the edge 250a of the slot 250. However, an overmolded cable grommet and a slot in the plane 211 may be different from such configurations as shown in Figure 10.

Figure 11 for example shows a close-up perspective of an overmolded cable grommet 280 arranged inside the slot 260 of the panel 211 of the box 210, according to various examples of the present disclosure. In a cartesian coordinate system, the plane 211 as shown in Figure 11 lies in the x-y-plane, wherein a normal vector of the plane 211 is parallel to the z-axis. The overmolded cable grommet 280 has a substantially rectangular shape, for example. The slot 260 in the plane 211 has a substantially circular shape comprising a substantially circular-shaped edge 260a. However, the slot 260 may be of any shape. In addition, comparatively smaller slots 261 and 262 are arranged adjacent to the slot 260. A number of such smaller slots may be just one or may be more than two. An arrangement of such smaller slots is not limited to any symmetrical arrangement, for example, but the smaller slots may be arbitrarily arranged adjacent to the slot 260.

The overmolded cable grommet 260 extends entirely beyond the edge 260a of the slot 260 and beyond the smaller slots 261 and 262. Hence, optionally, the overmolded cable grommet 280 may comprise additional portions, which are arrange and shaped such that, in case the overmolded cable grommet 280 is arranged inside the slot 260, the additional portions may be arranged inside the smaller slots 261 and 262. Hence, a fixation of the overmolded cable grommet 280 to the slot 260 and the panel 211 may be strengthened. In the example according to Figure 12, due to the smaller slot features for example, it may be understood that the overmolded cable grommet 280 has a complementary shape, which is complementary to the shape of the slot 260 and its adjacent smaller slots 261, 262.

Figure 12 for example shows a close-up perspective of an overmolded cable grommet 290 arranged inside the slot 270 of the panel 211 of the box 210, according to various examples of the present disclosure. In a cartesian coordinate system, the plane 211 as shown in Figure 12 lies in the x-y-plane, wherein a normal vector of the plane 211 is parallel to the z-axis. The overmolded cable grommet 290 has a substantially circular shape, for example. The slot 270 in the plane 211 has a substantially elliptical shape comprising a substantially elliptically shaped edge 270a. A longest diameter of the slot 270 may be arranged in the y-direction wherein a shortest diameter of the slot 270 may be arranged in the x-direction. Accordingly, the overmolded cable grommet 290 may comprise a portion, which has a substantially elliptical shape, wherein a longest diameter of the portion is shorter than the longest diameter of the slot 270 and wherein the longest diameter of the portion is longer than the shortest diameter of the slot 270. Hence, such portion of the overmolded cable grommet 290 may be inserted into the slot 270 so that the longest diameter of the portion is arranged substantially parallel to a direction of the longest diameter of the slot 270. Then, the overmolded cable grommet 290 may be rotated in the x-y-plane, until the longest diameter of the portion of the overmolded cable grommet 290 contacts the edge 270a of the slot 270 and gets at least partially compressed at the edge 270a of the slot 270, thereby being arranged inside the slot 270 to be hold in position. Hence, a fixation of the overmolded cable grommet 290 to the slot 270 and the panel 211 may be realized in an easy manner. In the example according to Figure 12, due to the elliptical features for example, it may be understood that the overmolded cable grommet 290 has a complementary shape, which is complementary to the shape of the slot 270.

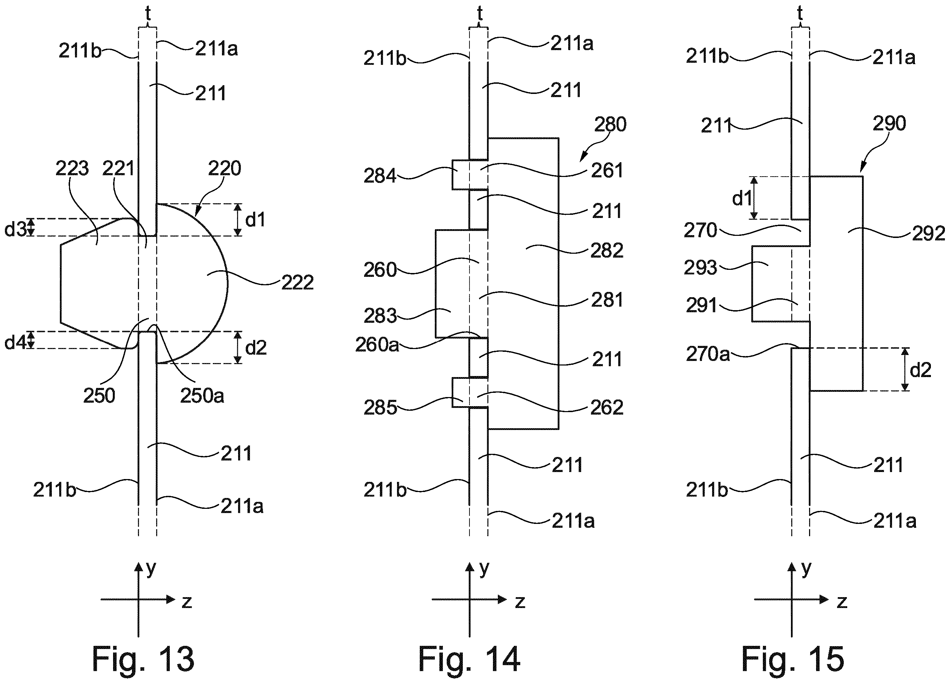

Referring now to Figure 13, Figure 13 schematically shows the overmolded cable grommet 220 according to Figure 10, according to several examples of the present disclosure. In Figure 13, the arrangement as shown in Figure 10 is rotated by 90° about the y-axis. Hence, Figure 13 shows the overmolded cable grommet 220 in the y-z-plane. The overmolded cable grommet 220 comprises a first portion 221, a second portion 222 and a third portion 223, wherein the second and third portions 222 and 223 are arranged at opposite sides of the first portion 221. Figure 13 further shows the panel 211 to comprise a first surface 211a and a second surface 211b opposite to the first surface 211a. The panel 211 has a thickness t. The panel 211 comprises the slot 250 and the slot edge 250a. The first portion 221 of the overmolded cable grommet 220 is arranged inside the slot 250 and is in contact with the slot edge 250a. The second portion 222 of the overmolded cable grommet 220 is arranged outside the slot 250 and extends beyond the slot edge 250a onto the first surface 211a. In the view shown in Figure 13, the second portion 222 extends onto the second surface 211a by a distance d1 on one side of the slot 250 and by a distance d2 on the other side of the slot 250. The distances d1 and d2 may be equal to or different from each other. The third portion 223 of the overmolded cable grommet 220 is arranged outside the slot 250 and extends beyond the slot edge 250a onto the second surface 211b. In the view shown in Figure 13, the third portion 223 extends onto the second surface 211b by a distance d3 on one side of the slot 250 and by a distance d4 on the other side of the slot 250. The distances d3 and d4 may be equal to or different from each other. Moreover, the ratios of distances d1/d2 and d3/d4 may be equal to or different from each other. Preferably, one of the second and third portions 222 and 223 is larger than the other, the one being intended to be placed on a side of the panel forming the inner side of the box such that a force required to pull the overmolded cable from the box is larger than a force preventing the overmolded cable grommet being pushed towards the center of the box. The third portion 223 may comprise a tampered shape with its diameter increasing in a direction from the third portion 223 toward the first portion 221. The overmolded cable grommet 220 may be arranged inside the slot 250 in that the third portion 223 is pushed through the slot 250 from the first surface 211a side toward the second surface 211b side. Hence, the tampered shape may be compressed when being pushed through the slot 250 and may be decompressed when leaving the slot 250, thereby generating the extensions onto the second surface 211b by the distances d3 and d4. In doing so, the overmolded cable grommet 220 is reliably held in position by the second and third portions 222 and 223. Further, the slot 250 is closed in an air-tight manner based on the first portion 221 entirely filling the slot 250 and based on the second and third portions 222 and 223 extending entirely beyond the slot edge 250a onto the first and second surfaces 211a and 211b.

Referring now to Figure 14, Figure 14 schematically shows the overmolded cable grommet 280 according to Figure 11, according to several examples of the present disclosure. In Figure 14, the arrangement as shown in Figure 11 is rotated by 90° about the y-axis. Hence, Figure 14 shows the overmolded cable grommet 280 in the y-z-plane.

The overmolded cable grommet 280 comprises a first portion 281, a second portion 282 and a third portion 283, wherein the second and third portions 282 and 283 are arranged at opposite sides of the first portion 281. The overmolded cable grommet 280 further comprises additional portions or pins 284 and 285, which extend from the side of the second portion 282 at which the first portion 281 is arranged. The pins 284 and 285 extend in a direction toward the third portion 283. The pins 284 and 285 are arranged at opposite sides of the first portion 281. Figure 14 further shows the panel 211 to comprise a first surface 211a and a second surface 211b opposite to the first surface 211a. The panel 211 has a thickness t. The panel 211 comprises the slot 260 and the slot edge 260a. The panel 211 further comprises the adjacent slots 261 and 262, which are arranged at opposite sides of the slot 260. The first portion 281 of the overmolded cable grommet 280 is arranged inside the slot 260 and is in contact with the slot edge 260a. The second portion 282 of the overmolded cable grommet 280 is arranged outside the slot 260 and extends beyond the slot edge 260a and beyond the adjacent slots 261 and 262 onto the first surface 211a. In the view shown in Figure 11, the pins 284 and 285 are further arranged inside the adjacent slots 261 and 262. The third portion 283 of the overmolded cable grommet 280 is arranged outside the slot 260. The third portion 283 does not extend beyond the slot edge 260a, at least not in the view shown in Figure 14. The overmolded cable grommet 280 may be held in position due to the first portion 281 being in contact with the slot edge 260a and due to the pins 284 and 285 being arranged inside the adjacent slots 261 and 262. The pins 284 and 285 may be pushed through the adjacent slots 261 and 262 to be in contact with the edges of the slots 261 and 262. In doing so, the overmolded cable grommet 280 is reliably held in position. Further, the slot 280 is closed in an air-tight manner based on the first portion 281 entirely filling the slot 260, based on the second portion 282 extending entirely beyond the slot edge 260a and beyond the adjacent slots 261 and 262, and based on the pins 284 and 285 entirely filling the adjacent slots 261 and 262. Moreover, it shall be noted as an example that the shape of the pins 284 and 285 is not limited to such shape as illustrated in Figure 14 as an example. For example, the shape of the pins 284 and/or 285 may comprise a tampered shape as outlined above with reference to the third portion 223 as illustrated according to Figure 13.

Referring now to Figure 15, Figure 15 schematically shows the overmolded cable grommet 290 according to Figure 12, according to several examples of the present disclosure. In Figure 15, the arrangement as shown in Figure 12 is rotated by 90° about the y-axis. Hence, Figure 15 shows the overmolded cable grommet 290 in the y-z-plane.

The overmolded cable grommet 290 comprises a first portion 291, a second portion 292 and a third portion 293, wherein the second and third portions 292 and 293 are arranged at opposite sides of the first portion 291. The first and third portions 291 and 293 have such substantially elliptical shape as outlined above with reference to Figure 12. Figure 15 further shows the panel 211 to comprise a first surface 211a and a second surface 211b opposite to the first surface 211a. The panel 211 has a thickness t. The panel 211 comprises the slot 270 and the slot edge 270a. The slot 270 has such substantially elliptical shape as outlined above with reference to Figure 12. The first portion 291 of the overmolded cable grommet 290 is arranged inside the slot 270 in that the overmolded cable grommet 290, once the first and third portions 291 and 293 are inserted into the slot 270, is rotated in the x-y-plane until the first portion 291 contacts the slot edge 270a. In the view shown in Figure 15, it may be understood that the first portion 291 contacts the slot edge 270a in the x-direction and does not contact the edge 270a in the y-direction. The second portion 292 of the overmolded cable grommet 290 is arranged outside the slot 270 and extends beyond the slot edge 270a onto the first surface 211a. In the view shown in Figure 15, the second portion 222 extends onto the second surface 211a by a distance d1 on one side of the slot 270 and by a distance d2 on the other side of the slot 270. The distances d1 and d2 may be equal to or different from each other. The third portion 293 of the overmolded cable grommet 290 is arranged outside the slot 270. The third portion 293 does not extend beyond the slot edge 270a, at least not in the view shown in Figure 15. The overmolded cable grommet 290 may be held in position due to the rotation of the overmolded cable grommet 290 to bring the first portion 291 into contact with the slot edge 270a. In doing so, the overmolded cable grommet 290 is reliably held in position. Further, the slot 290 is closed in an air-tight manner based on the second portion 292 extending entirely beyond the slot edge 270a.

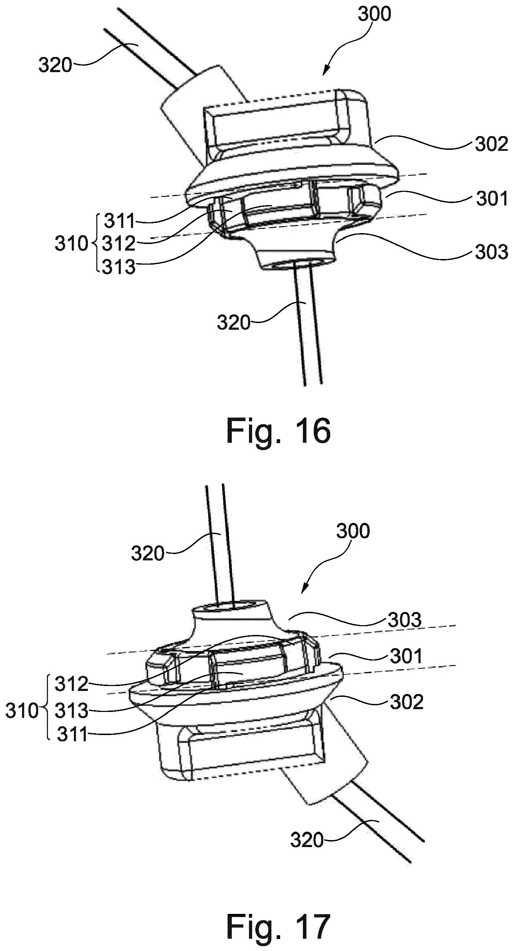

Referring now to Figures 16 and 17, Figures 16 and 17 show an overmolded cable grommet 300 from different perspectives according to several examples of the present disclosure. The overmolded cable grommet 300 comprises a first portion 301, a second portion 302 and a third portion 303, wherein the second and third portions 302 and 303 are arranged at opposite sides of the first portion 301. A wire 320 is illustrated to run through the overmolded cable grommet 300. The overmolded cable grommet 300 is to be arranged inside a slot. For such arrangement, the first portion 301 of the overmolded cable grommet 300 comprises a locking mechanism 310. The locking mechanism 310 may represent a counterpart to a locking mechanism provided at the slot. Hence, the overmolded cable grommet 300 may be arranged inside the slot in a key-keyhole-manner, for example. The locking mechanism 310 comprises a recess portion or groove portion 311, an arrangement portion or introduction portion 312, and a protrusion portion 313. Hence, at the slot, a counterpart to the locking mechanism 310 may comprise a locking protrusion portion. The overmolded cable grommet 300 may be arranged inside the slot so that the arrangement portion 312 is arranged to receive the slot's locking protrusion portion. Then, the overmolded cable grommet 300 may be rotated so that the slot's locking protrusion portion slides into the groove portion 311 and is held in position by the protrusion portion 313. Hence, the overmolded cable grommet 300 may be held in position with increased reliability and an air-tight closure may be further improved. Moreover, it shall be noted as a mere example for illustrative purposes, that the overmolded cable grommet 300 according to Figures 16 and 17 can be connected to such additional slot 190 in panel 112 of the box 110 as illustrated in Figure 2.

In the following, further examples of the present disclosure are provided.

In particular, according to several examples of the present disclosure, there is provided a box adapted to be installed inside a heat pump housing, the box optionally being one of an electric equipment box and a refrigerant box. The box comprises a box panel comprising a slot; and an overmolded cable grommet, molded around a wire. The overmolded cable grommet is arranged inside the slot, contacts an edge of the slot and extends onto a first surface of the box panel, such that the overmolded cable grommet is restricted from moving in at least one direction that is perpendicular to the first surface. The box is substantially air-tight when an electronic device inside the box is connected to a source that is external to the box via the wire passing through the overmolded cable grommet.

Regarding the term substantially air-tight, the following may be considered. Namely, according to several examples of the present disclosure, there is a case where a sealing against the refrigerant is wanted, for example. In addition, there is a case where to control the level of leakage and/or tightness of the box is wanted, for example. So, the sealing is restricted by using openings sized for this purpose, and the areas are sealed where no leakage is wanted. This type of case may arise in, particular, when an extraction fan is present at the interface of the enclosure or box, and for which it is necessary to have a sealing defect in the enclosure which allows a flow of air through the fan. Otherwise, there would be no air to extract and a vacuum is created. It may therefore be a case where it is wanted to control, in the box, the vacuum level and/or pressure difference level in relation to the installation environment.

This solution is advantageous over existing solutions, in that it is less expensive, especially compared to split cable entry systems. The assembly of such solution is timesaving in that it is comparatively quick and easy, for example since pre-assembled building blocks may be used, like the box and the wire or cable around which the grommet has been molded. Moreover, an air-tightening is not impacted by wire or cable dimension variations and tolerances. In addition, no tightening torque guaranteeing may be necessary. Further, based on the solution as disclosed herein, it is enabled to fit bulky components, like a pre-wired control board, connectors or fairings, a pre-wired driver coil, a filter pre-mounted on a harness or components, for example, inside the box, without decrease the ability to fulfill air-tightness requirements.

Moreover, according to several examples, the overmolded cable grommet arranged inside the slot may be adapted to have restricted movement in both directions perpendicular to the first surface. Both directions may be understood to comprise a positive direction perpendicular to the first surface and a negative direction perpendicular to the first surface. Preferably, the overmolded cable grommet may further extend onto a second surface of the box panel opposite to the first surface.

Due to the movement being restricted in both directions perpendicular to the first surface, the overmolded cable grommet is held in the slot more reliably. In addition, in case the overmolded cable grommet further extends onto the second surface, the overmolded cable grommet is held in the slot with even more increased reliability.

Moreover, according to several examples, the overmolded cable grommet, when considered in a thickness-direction of the box panel, may comprise a first portion and a second portion. The first portion being configured to have a complementary shape, complementary to a shape of the slot. The second portion is arranged on a first side of the first portion and is configured to have a perimeter shape adapted to extend beyond the edge of the slot. The overmolded cable grommet may be arranged so that the first portion is arranged inside the slot, and so that the second portion is arranged outside the slot and extends onto the first surface of the box panel, such as to substantially close the slot in an air-tight manner.

Such configuration of the overmolded cable grommet comprises several advantages. For example, since the second portion may extend onto the first surface of the box panel to substantially close the slot in an air-tight manner, the first portion may not necessarily close or fill the slot entirely, i.e. in an air-tight manner. Hence, the first portion may be configured to arrange the overmolded cable grommet inside the slot by use of a locking mechanism, for example, without the necessity to also guarantee an air-tight closure. Hence, the first portion may be configured to focus on arranging the overmolded cable grommet inside the slot in a potentially most reliable, repeatable and/or convenient manner. Moreover, a complementary shape may comprise that a shape of the overmolded cable grommet matches a shape of the slot, for example in that the shape of the overmolded cable grommet is the negative of the shape of the slot. Further, complementary shape may also comprise that the shape of the overmolded cable grommet corresponds to the shape of the slot in a key-to-keyhole manner, meaning that an overmolded cable grommet having a certain shape may only be arranged inside a slot having a correspondingly certain shape. The shape of the second portion may be any shape as long as the slot is closed in an air-tight manner.

Moreover, according to several examples, the overmolded cable grommet may further comprise a third portion arranged on a second side of the first portion opposite to the first side and having a perimeter shape adapted to at least partially extend beyond the edge of the slot. The overmolded cable grommet may further be arranged so that the third portion is arranged outside the slot and extends onto the second surface of the box panel.

Regarding the perimeter shape, said in other words, for example, the second portion and/or the third portion may have a shape equally large as the slot or at least partially larger than the first portion, not necessary on the whole perimeter but at least on a portion of the perimeter of the first portion.

Accordingly, the overmolded cable grommet is held in the slot with even more increased reliability. Moreover, the second and the third portions may each close the slot in a substantially air-tight manner. Hence, reliability of the air-tight closing is further increased.

Moreover, according to several examples, the box may further comprise a closing panel for opening and closing the box, wherein the closing panel contacts an edge of the box panel. The slot may be arranged at the edge of the box panel so that at least part of the edge of the slot is formed by the closing panel.

Accordingly, in case the closing panel is removed, the overmolded cable grommet may be slid in position and may be held in position inside the slot once the closing panel is rearranged. Hence, the closing panel may at least to some extent hold or compress the arranged overmolded cable grommet inside the slot. Hence, a pushing of the overmolded cable grommet through the slot may be avoided and a deformation of the overmolded cable grommet during the arrangement of the overmolded cable grommet inside the slot is at least reduced. Therefore, a risk of damaging the overmolded cable grommet during the arrangement is reduced. Moreover, such sliding in and out of position may allow to rearrange the overmolded cable grommet several times inside the slot without putting any stress on the overmolded cable grommet, which may occur when pushing or pulling the overmolded cable grommet. Furthermore, replacement of the overmolded cable grommet may be facilitated.

Moreover, according to several examples, the overmolded cable grommet may further comprise a compressible material and may further have a tapered and/or threaded portion configured to be pushed through the slot and/or optionally through a small hole that is optionally provided adjacent to the slot. The tapered and/or threaded portion may widen, in a direction from an end section of the overmolded cable grommet to a middle section of the overmolded cable grommet, to a diameter which is larger in an uncompressed state than a largest diameter of the slot or of the optional small hole. The overmolded cable grommet may be arranged inside the slot by being pushed through the slot and optionally through the small hole, so that a section of the tapered and/or threaded portion is compressed at the slot and/or the optionally provided small hole.

Accordingly, the tapered and/or threaded portion may provide any easy solution for arranging the overmolded cable grommet inside the slot. Moreover, pushing such tapered and/or threaded portion alternatively and optionally through a small hole provided adjacent to the slot, the overmolded cable grommet may be held in position even more reliably and an air-tight closure is provided with even more reliability.

Moreover, according to several examples, the slot of the box panel may represent a first slot and wherein the overmolded cable grommet may represent a first overmolded cable grommet. The box panel may further comprise a second slot, which has a size and/or shape different from the first slot. The box may further comprise a second overmolded cable grommet. The respective first and second overmolded cable grommets each being adapted to fit a respective one of the first and second slots.

Accordingly, errors in the arrangement of different overmolded cable grommets in different slots is at least reduced, in that it may be avoided that an overmolded cable grommet is arranged inside a wrong slot, i.e. inside a slot where another overmolded cable grommet is intended for arrangement. Furthermore, an installation of devices inside the box is provided with higher flexibility, since several different slots comprising several different overmolded cable grommets being molded around several different wires may be used.

Moreover, according to several examples, the slot may represent a first slot and wherein the overmolded cable grommet may represent a first overmolded cable grommet molded around a first wire. The box panel may further comprise a second slot and the box may further comprise a second overmolded cable grommet molded around a second wire and arranged in the second slot. When the first and second overmolded cable grommets are arranged in the first and second slots, the first and second wires may extend to different lengths inside the box.

Accordingly, since the first and second wires may extend to different lengths inside the box, the first and second wires may be connected to different devices inside the box. For example, the different devices inside the box may be arranged inside the box so that a wire, which extends to a comparatively short length inside the box, may only be connected to a certain device inside the box, which is arranged comparatively close to the box panel comprising the slot in which the overmolded cable grommet comprising the wire of the comparatively short length is arranged. Hence, installation errors may be even further reduced.

Moreover, according to several examples, the overmolded cable grommet may have a bulb shape having a cylindrical-shaped portion to be arranged at least partially inside the slot and a circular-shaped portion arranged outside the slot, wherein the circular-shaped portion has a diameter between 10mm and 30mm. Additionally or alternatively, the overmolded cable grommet arranged inside the slot may have a maximum diameter of equal to or less than 25mm. Additionally or alternatively, the overmolded cable grommet may comprise at least one of: ABS, EPDM rubber, PBT, PVC, TPE, hotmelt resin, and nylon. Additionally or alternatively, the overmolded cable grommet may be overmolded using at least two materials of different hardness, in particular shore hardness, such that a predetermined section may be softer and/or more flexible to accommodate higher tolerances and/or imperfections. Additionally or alternatively, the overmolded cable grommet may be configured to shrink around and/or bond to an outer surface of the wire to pass through the overmolded cable grommet. Additionally or alternatively, the overmolded cable grommet may be an air-tight clip-on plastic piece to the slot from the box panel. Additionally or alternatively, the overmolded cable grommet may be interference fitted into the slot. Additionally or alternatively, the overmolded cable grommet may be molded directly onto the wire, wherein the grommet preferably is fixed to the cable, such that no translation of the grommet along the cable is possible.

Hence, a variety in applying the overmolded cable grommet is increased. In particular, the maximum diameter of equal to or less than 25mm may enable an application of the overmolded cable grommet on a huge variety of different wires.

Moreover, there is disclosed a heat pump housing in which the box as described above, for example with reference to Figures 2 to 15, is installed. The heat pump housing may preferably further comprise a refrigerant circuit in which a flammable refrigerant is used. The flammable refrigerant may preferably be propane.

The solution is advantageous over existing solutions, in that the heat pump housing may be equipped with the advantageous box as described above with reference to Figures 2 to 15, for example. Moreover, the such may be used in different ways. For example, to avoid a flammable refrigerant leaking from the refrigerant circuit to reach electronic devices, which are protected inside the box. Additionally or alternatively, in case the refrigerant circuit may be installed inside such box, a flammable refrigerant leaking from the refrigerant circuit may not exit the box. Hence, electronic devices outside the box are protected.

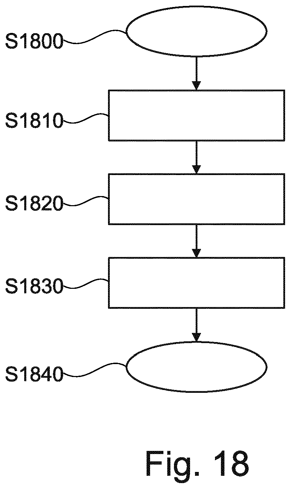

Referring now to Figure 18, Figure 18 shows a flowchart according to several examples of the present disclosure. In particular, Figure 18 shows a method for manufacturing a box installable in a heat pump housing, wherein the box is such box as described above with reference to Figures 2 to 15, for example.

In S1800, the method is started.

In S1810, the comprises providing a box panel comprising a slot for passing a wire through.

In S1820, the method further comprises providing at least one wire with a cable grommet by overmolding said cable grommet around the wire at a predetermined longitudinal position along the wire, using a mold shape that is adapted to result in a cable grommet having a shape complementary to a shape of the slot such that the cable grommet closes off the slot in a substantially air-tight manner and is restricted from moving in at least one direction perpendicular to a surface of the box panel after placement in the slot.

In S1830, the method further comprises placing the overmolded cable grommet within the slot of the box panel.

In S1840, the method ends.

Such method is advantageous over existing solutions, in that it provides a less expensive, timesaving and easily to implement solution, for example since pre-assembled building blocks may be used, like the box and the cable around which the grommet has been molded. Moreover, an air-tightening is not impacted by wire or cable dimension variations and tolerances. In addition, no tightening torque guaranteeing may be necessary. Further, such manufacturing enables to fit bulky components, like a pre-wired control board, connectors or fairings, a pre-wired driver coil, a filter pre-mounted on a harness or components, for example, inside the box, without decrease the ability to fulfill air-tightness requirements.

Moreover, according to several examples, the step of providing the box panel comprising the slot may comprise the providing of the slot at an edge of the box panel, such that an edge of the slot forms a part of the edge of the box panel. The placing of the overmolded cable grommet may comprise the sliding of the cable grommet into the slot in a direction substantially parallel to a surface of the box panel.

Accordingly, a pushing of the overmolded cable grommet through the slot may be avoided and a deformation of the overmolded cable grommet during the arrangement of the overmolded cable grommet inside the slot is at least reduced. Therefore, a risk of damaging the overmolded cable grommet during the arrangement is reduced. Moreover, such sliding in and out of position may allow to rearrange the overmolded cable grommet several times inside the slot without putting any stress on the overmolded cable grommet, which may occur when pushing or pulling the overmolded cable grommet. Furthermore, replacement of the overmolded cable grommet may be facilitated.

Moreover, according to several examples, the placing of the overmolded cable grommet may comprise pushing the overmolded cable grommet into the slot in a direction substantially perpendicular to a surface of the box panel. Optionally, the placing further comprises rotating the overmolded cable grommet in a direction substantially parallel to the surface to establish a locking of the overmolded cable grommet in both directions substantially perpendicular to the surface. Both directions may be understood to comprise a positive direction perpendicular to the surface and a negative direction perpendicular to the surface.

Accordingly, the arrangement of the overmolded cable grommet may be facilitated in that merely a pushing is required and any tools may be avoided. Moreover, due to the rotating the overmolded cable grommet, the overmolded cable grommet may be locked inside the slot more reliably. Further, an air-tight closure is provided with even more reliability.

Moreover, according to several examples, the method may further comprise providing the box panel with a second slot for passing a wire through. The second slot preferably has a different shape and/or size from the slot. The method may further comprise providing another wire with a second cable grommet by molding said second cable grommet around the another wire at another predetermined longitudinal position along the another wire, using a second mold shape that is adapted to result in a cable grommet having a shape complementary to a shape of the second slot.

Accordingly, errors in the arrangement of different overmolded cable grommets in different slots is at least reduced, in that it may be avoided that an overmolded cable grommet is arranged inside a wrong slot, i.e. inside a slot where another overmolded cable grommet is intended for arrangement. Furthermore, an installation of devices inside the box is provided with higher flexibility, since several different slots comprising several different overmolded cable grommets being molded around several different wires may be used.

Moreover, there is disclosed a use of an overmolded cable grommet for air-tightening a wire entry of a box installable in a heat pump housing. The box comprises a box panel comprising a slot. The use comprises arranging the overmolded cable grommet inside the slot to contact an edge of the slot and to extend onto a first surface of the box panel.

Such solution is advantageous over existing solutions, in that it is less expensive, especially compared to split cable entry systems. The assembly of such solution is timesaving in that it is comparatively quick and easy, for example since pre-assembled building blocks may be used, like the box and the cable around which the grommet has been molded. Moreover, an air-tightening is not impacted by wire or cable dimension variations and tolerances. In addition, no tightening torque guaranteeing may be necessary. Further, based on the solution according to the first aspect, it is enabled to fit bulky components, like a pre-wired control board, connectors or fairings, a pre-wired driver coil, a filter pre-mounted on a harness or components, for example, inside the box, without decrease the ability to fulfill air-tightness requirements.

The indefinite article "a" or "an" does not exclude a plurality. In addition, the articles "a" and "an" as used herein should generally be construed to mean "one or more" unless specified otherwise or clear from the context to be directed to a singular form.

Unless specified otherwise, or clear from the context, the phrases "one or more of A, B and C", "at least one of A, B, and C", and "A, B and/or C" as used herein are intended to mean all possible permutations of one or more of the listed items. That is, the phrase "A and/or B" means (A), (B), or (A and B), while the phrase "A, B, and/or C" means (A), (B), (C), (A and B), (A and C), (B and C), or (A, B, and C).

The term "comprising" does not exclude other elements or steps. Furthermore, the terms "comprising", "including", "having" and the like may be used interchangeably herein.

### Reference Signs

- 100: heat pump system
- 110: box
- 111 to 115: panels of the box 110
- 111a to 111d: edges of panel 111
- 120a: first portion of overmolded cable grommet 124
- 120b: second portion of overmolded cable grommet 124
- 120c: third portion of overmolded cable grommet 124
- 121 to 124: overmolded cable grommets
- 121a to 124a: part of edges of slots 121 to 124
- 131 to 134: wires running through overmolded cable grommet 121 to 124
- 141 to 144: slots for overmolded cable grommets 121 to 124
- 141a to 144a: edges of the slots 141 to 144
- 190: slot
- 210: box
- 211 to 216: panels of the box 210
- 211a: first surface of box panel 211
- 211b: second surface of box panel 211
- t: thickness of box panel 211
- 220, 280, 290: overmolded cable grommets
- 221, 222, 223: first to third portions of overmolded cable grommet 220
- 281, 282, 283: first to third portions of overmolded cable grommet 280
- 291, 292, 293: first to third portions of overmolded cable grommet 290
- 230: wire
- 240: electronic device
- 250, 260, 270: slot in panel 211
- 250a, 260a, 270a: edges of slots 250, 260, 270
- d1, d2, d3, d4: extension distances
- 300: overmolded cable grommet
- 301, 302, 303: first to third portions of overmolded cable grommet 300
- 310: locking mechanism of overmolded cable grommet 300
- 311: recess portion/groove portion
- 312: arrangement portion/introduction portion
- 313: protrusion portion
- 320: wire

## Claims

1. A box (110; 210) adapted to be installed inside a heat pump box, the box (110; 210) optionally being one of an electric equipment box and a refrigerant box, the box (110; 210) comprising:
a box panel (111; 211) comprising a slot (141, 142, 143, 144; 250, 260, 270); and
an overmolded cable grommet (121, 122, 123, 124; 220, 280, 290, 300), molded around a wire (131, 132, 133, 134; 230; 320),
wherein the overmolded cable grommet (121, 122, 123, 124; 220, 280, 290, 300) is arranged inside the slot (141, 142, 143, 144; 250, 260, 270), contacts an edge (141a, 142a, 143a, 144a; 250a, 260a, 270a) of the slot (141, 142, 143, 144; 250, 260, 270) and extends onto a first surface (211a) of the box panel (111; 211), such that the overmolded cable grommet (121, 122, 123, 124; 220, 280, 290, 300) is restricted from moving in at least one direction that is perpendicular to the first surface (211a), and
wherein the box (110; 210) is substantially air-tight when an electronic device (240) inside the box (110; 210) is connected to a source that is external to the box (110; 210) via the wire (131, 132, 133, 134; 230; 320) passing through the overmolded cable grommet (121, 122, 123, 124; 220, 280, 290, 300).

2. The box (110; 210) according to claim 1, wherein the overmolded cable grommet (121, 122, 123, 124; 220, 280, 290, 300) arranged inside the slot (141, 142, 143, 144; 250, 260, 270) is adapted to have restricted movement in both directions perpendicular to the first surface (211a), preferably wherein the overmolded cable grommet (121, 122, 123, 124; 220, 280, 290, 300) further extends onto a second surface (211b) of the box panel (111; 211) opposite to the first surface (211a).

3. The box (110; 210) according to any of the preceding claims,
wherein the overmolded cable grommet (121, 122, 123, 124; 220, 280, 290, 300), when considered in a thickness-direction of the box panel (111; 211), comprises a first portion (120a; 221, 281, 291; 301) and a second portion (120b; 222, 282, 292; 302), the first portion (120a; 221, 281, 291; 301) being configured to have a complementary shape, complementary to a shape of the slot (141, 142, 143, 144; 250, 260, 270), and the second portion (120b; 222, 282, 292; 302) is arranged on a first side of the first portion (120a; 221, 281, 291; 301) and is configured to have a perimeter shape adapted to extend beyond the edge (141a, 142a, 143a, 144a; 250a, 260a, 270a) of the slot (141, 142, 143, 144; 250, 260, 270); and
wherein the overmolded cable grommet (121, 122, 123, 124; 220, 280, 290, 300) is arranged so that the first portion (120a; 221, 281, 291; 301) is arranged inside the slot (141, 142, 143, 144; 250, 260, 270), and so that the second portion (120b; 222, 282, 292; 302) is arranged outside the slot (141, 142, 143, 144; 250, 260, 270) and extends onto the first surface (211a) of the box panel (111; 211), such as to substantially close the slot (141, 142, 143, 144; 250, 260, 270) in an air-tight manner.

4. The box (110; 210) according to claim 3,
wherein the overmolded cable grommet (121, 122, 123, 124; 220, 280, 290, 300) further comprises a third portion (120c; 223, 283, 293; 303) arranged on a second side of the first portion (120a; 221, 281, 291; 301) opposite to the first side and having a perimeter shape adapted to at least partially extend beyond the edge (141a, 142a, 143a, 144a; 250a, 260a, 270a) of the slot (141, 142, 143, 144; 250, 260, 270), and
wherein the overmolded cable grommet (121, 122, 123, 124; 220, 280, 290, 300) is further arranged so that the third portion (120c; 223) is arranged outside the slot (141, 142, 143, 144; 250, 260, 270) and extends onto the second surface (211b) of the box panel (111; 211).

5. The box (110; 210) according to any of the preceding claims, further comprising a closing panel for opening and closing the box (110; 210), wherein the closing panel contacts an edge (111a) of the box panel (111), and
wherein the slot (141, 142, 143, 144) is arranged at the edge (111a) of the box panel (111) so that at least part of the edge (141a, 142a, 143a, 144a) of the slot (141, 142, 143, 144) is formed by the closing panel.

6. The box (110; 210) according to any of the preceding claims,
wherein the overmolded cable grommet (220, 280) further comprises a compressible material and further has a tapered and/or threaded portion (223, 284, 285) configured to be pushed through the slot (250, 260) and/or optionally through a small hole (261, 262) that is optionally provided adjacent to the slot (260), wherein the tapered and/or threaded portion (223) widens, in a direction from an end section of the overmolded cable grommet (220) to a middle section of the overmolded cable grommet (220), to a diameter which is larger in an uncompressed state than a largest diameter of the slot (260) or of the optional small hole (261, 262); and
wherein the overmolded cable grommet (220, 280) is arranged inside the slot (250, 260) by being pushed through the slot (250, 260) and optionally through the small hole (261, 262), so that a section of the tapered and/or threaded portion (223, 284, 285) is compressed at the slot (250, 260) and/or the optionally provided small hole (261, 262).

7. The box (110; 210) according to any of the preceding claims,
wherein the slot (141, 142, 143, 144; 250, 260, 270) of the box panel (111; 211) represents a first slot and wherein the overmolded cable grommet (121, 122, 123, 124; 220, 280, 290, 300) represents a first overmolded cable grommet;
wherein the box panel (111; 211) further comprises a second slot, which has a size and/or shape different from the first slot; and
wherein the box (110; 210) further comprises a second overmolded cable grommet; the respective first and second overmolded cable grommets each being adapted to fit a respective one of the first and second slots.

8. The box (110; 210) according to any of the preceding claims,
wherein the slot (141, 142, 143, 144; 250, 260, 270) represents a first slot and wherein the overmolded cable grommet (121, 122, 123, 124; 220, 280, 290, 300) represents a first overmolded cable grommet molded around a first wire,
the box panel (111; 211) further comprising a second slot and the box (110; 210) further comprising a second overmolded cable grommet molded around a second wire and arranged in the second slot,
wherein, when the first and second overmolded cable grommets are arranged in the first and second slots, the first and second wires extend to different lengths inside the box (110; 210).

9. The box (110; 210) according to any of the preceding claims,
wherein the overmolded cable grommet has a bulb shape having a cylindrical-shaped portion to be arranged at least partially inside the slot (141, 142, 143, 144; 250, 260, 270) and a circular-shaped portion arranged outside the slot (141, 142, 143, 144; 250, 260, 270), wherein the circular-shaped portion has a diameter between 10mm and 30mm; and/or
wherein the overmolded cable grommet (121, 122, 123, 124; 220, 280, 290, 300) arranged inside the slot (141, 142, 143, 144; 250, 260, 270) has a maximum diameter of equal to or less than 25mm;
wherein the overmolded cable grommet (121, 122, 123, 124; 220, 280, 290, 300) comprises at least one of: ABS, EPDM rubber, PBT, PVC, TPE, hotmelt resin, and nylon; and/or
wherein the overmolded cable grommet (121, 122, 123, 124; 220, 280, 290, 300) may be overmolded using at least two materials of different hardness, in particular shore hardness, such that a predetermined section may be softer and/or more flexible to accomodate higher tolerances and/or imperfections; and/or
wherein the overmolded cable grommet (121, 122, 123, 124; 220, 280, 290, 300) is configured to shrink around and/or bond to an outer surface of the wire (131, 132, 133, 134; 230; 320) to pass through the overmolded cable grommet (121, 122, 123, 124; 220, 280, 290, 300); and/or
wherein the overmolded cable grommet is an air-tight clip-on plastic piece to the slot (141, 142, 143, 144; 250, 260, 270) from the box panel (111; 211); and/or
wherein the overmolded cable grommet (220, 280, 290) is interference fitted into the slot (250, 260, 270); and/or
wherein the overmolded cable grommet (121, 122, 123, 124; 220, 280, 290, 300) is molded directly onto the wire (131, 132, 133, 134; 230; 320).

10. A heat pump box in which the box (110; 210) according to any of the preceding claims is installed, said heat pump box preferably further comprising a refrigerant circuit in which a flammable refrigerant is used, said flammable refrigerant preferably being propane.

11. A method for manufacturing a box (110; 210) installable in a heat pump box according to any of claims 1 to 9, the method comprising:
providing a box panel (111; 211) comprising a slot (141, 142, 143, 144; 250, 260, 270) for passing a wire (131, 132, 133, 134; 230; 320) through,
providing at least one wire (131, 132, 133, 134; 230; 320) with a cable grommet by overmolding said cable grommet around the wire (131, 132, 133, 134; 230; 320) at a predetermined longitudinal position along the wire (131, 132, 133, 134; 230; 320), using a mold shape that is adapted to result in a cable grommet having a shape complementary to a shape of the slot (141, 142, 143, 144; 250, 260, 270) such that the cable grommet closes off the slot (141, 142, 143, 144; 250, 260, 270) in a substantially air-tight manner and is restricted from moving in at least one direction perpendicular to a surface of the box panel (111; 211) after placement in the slot (141, 142, 143, 144; 250, 260, 270); and
placing the overmolded cable grommet (121, 122, 123, 124; 220, 280, 290, 300) within the slot (141, 142, 143, 144; 250, 260, 270) of the box panel (111; 211).

12. The method according to claim 11, wherein the step of providing the box panel (111; 211) comprising the slot (141, 142, 143, 144; 250, 260, 270) comprises the providing of the slot (141, 142, 143, 144; 250, 260, 270) at an edge (111a) of the box panel (111), such that an edge (141a, 142a, 143a, 144a) of the slot (141, 142, 143, 144) forms a part of the edge (111a) of the box panel (111), and
wherein the placing of the overmolded cable grommet (121, 122, 123, 124) comprises the sliding of the cable grommet into the slot (141, 142, 143, 144) in a direction substantially parallel to a surface of the box panel (111).

13. The method according to claim 11, wherein the placing of the overmolded cable grommet (220, 280, 290, 300) comprises pushing the overmolded cable grommet (220, 280, 290, 300) into the slot (250, 260, 270) in a direction substantially perpendicular to a surface of the box panel (211) and, optionally, further comprises rotating the overmolded cable grommet (290, 300) in a direction substantially parallel to the surface to establish a locking of the overmolded cable grommet (290, 300) in both directions substantially perpendicular to the surface.

14. The method according to any of claims 11 to 13, further comprising:
providing the box panel (111; 211) with a second slot for passing a wire through, the second slot preferably having a different shape and/or size from the slot (141, 142, 143, 144; 250, 260, 270), and
providing another wire with a second cable grommet by molding said second cable grommet around the another wire at another predetermined longitudinal position along the another wire, using a second mold shape that is adapted to result in a cable grommet having a shape complementary to a shape of the second slot.

15. Use of an overmolded cable grommet (121, 122, 123, 124; 220, 280, 290, 300) for air-tightening a wire entry of a box (110; 210) installable in a heat pump box, wherein the box (110; 210) comprises a box panel (111; 211) comprising a slot (141, 142, 143, 144; 250, 260, 270),
the use comprising: arranging the overmolded cable grommet (121, 122, 123, 124; 220, 280, 290, 300) inside the slot (141, 142, 143, 144; 250, 260, 270) to contact an edge (141a, 142a, 143a, 144a; 250a, 260a, 270a) of the slot (141, 142, 143, 144; 250, 260, 270) and to extend onto a first surface (211a) of the box panel (111; 211).
